# EUROPÄISCHE PATENTSCHRIFT

(11) **EP 3 713 030 B1**
(45) Veröffentlichungstag und Bekanntmachung des Hinweises auf die Patenterteilung: **23.11.2022**
(21) Anmeldenummer: 19163396.5
(22) Anmeldetag: 18.03.2019
(51) Int. Cl.: H02H 3/04, H02H 3/16, H02H 3/44, H02H 7/26, G01R 31/08, H02J 1/06, G01R 31/52

(54) **ORTEN EINES ERDSCHLUSSES IN EINEM GLEICHSTROMNETZ MIT MEHREREN LASTZONEN**
LOCATING AN EARTH FAULT IN A DC NETWORK WITH MULTIPLE LOAD ZONES
LOCALISER UNE FUITE À LA TERRE DANS UN RÉSEAU À COURANT CONTINUE AVEC PLUSIEURS ZONES DE CHARGE

(43) Veröffentlichungstag der Anmeldung: 23.09.2020
(73) Patentinhaber: Siemens Aktiengesellschaft, 80333 München (DE)
(72) Erfinder: Schierling, Hubert, 91052 Erlangen (DE); Weis, Benno, 91334 Hemhofen (DE)

(56) Entgegenhaltungen:
- EP-A1- 3 220 501
- US-B1- 6 671 144

## Beschreibung

Die Erfindung betrifft ein Verfahren zum Orten eines Erdschlusses in einem Gleichstromnetz, dem mehrere Lastzonen zuschaltbar sind.

Ein gegenüber einem Erdpotential isoliertes oder über eine hohe Impedanz geerdetes Gleichstromnetz kann bei einem Erdschluss eines Gleichspannungspotentials weiter betrieben werden. Der Erdschluss selbst kann während des Betriebs durch die Messung und Auswertung der Spannungen zwischen den Gleichspannungspotentialen des Gleichstromnetzes und einem Erdpotential leicht detektiert werden. Allerdings ist es schwierig, diejenige an dem Gleichstromnetz angeschlossene Lastzone zu identifizieren, in der der Erdschluss aufgetreten ist. Die Identifizierung derjenigen Lastzone, in der der Erdschluss aufgetreten ist, ist jedoch wichtig, um die fehlerhafte Lastzone abzuschalten und den Erdschluss zu beseitigen. Um die fehlerhafte Lastzone zu identifizieren, könnte beispielsweise an einer Verbindungsstelle jeder Lastzone mit dem Gleichstromnetz, beispielsweise am Eingang eines Schaltschranks, ein so genannter Common-Mode-Strom, das heißt ein Fehlerstrom, der die Summe der Ströme in den beiden Anschlussleitungen der Lastzone zu den Hauptleitungen des Gleichstromnetzes ist, gemessen werden. Wenn einer der Common-Mode-Ströme von Null verschieden ist, weist dies darauf hin, dass der Erdschluss in der zugehörigen Lastzone aufgetreten ist. Die Messungen der Common-Mode-Ströme könnten beispielsweise permanent oder manuell durch Wartungspersonal durchgeführt werden. Jedoch sind derartige Messungen in jedem Fall aufwändig.

Die Patentschrift EP3220051A1 offenbart ein Flugzeug mit einem Gleichstromnetz zur Versorgung elektronische Systeme, welche jeweils durch eine Vorrichtung zur Ortung eines Erdschlusses abgesichert werden.

Die Patentschrift US667144B1 offenbart ein Verfahren und eine Vorrichtung, um Erdschlüsse zu detektieren, und um eine Spannungsversorgung von einem Erdschluss zu trennen.

Der Erfindung liegt die Aufgabe zugrunde, ein verbessertes Verfahren zum Orten eines Erdschlusses in einem Gleichstromnetz anzugeben, dem mehrere Lastzonen zuschaltbar sind.

Die Aufgabe wird erfindungsgemäß durch ein Verfahren mit den Merkmalen des Anspruchs 1, ein Gleichstromnetz mit den Merkmalen des Anspruchs 13 und ein Gleichstromnetz mit den Merkmalen des Anspruchs 14 gelöst.

Vorteilhafte Ausgestaltungen der Erfindung sind Gegenstand der Unteransprüche.

Das erfindungsgemäße Verfahren dient zum Orten eines Erdschlusses in einem Gleichstromnetz, dem mehrere Lastzonen zuschaltbar sind, wobei jede Lastzone direkt oder indirekt mit wenigstens einer Hauptleitung des Gleichstromnetzes über ein der Lastzone zugeordnetes elektrisches Bauelement verbunden ist, das einen netzseitigen Anschluss und einen lastzonenseitigen Anschluss aufweist und an dem bei einem Stromfluss durch das Bauelement eine Spannung zwischen dem netzseitigen Anschluss und dem lastzonenseitigen Anschluss abfällt. Bei dem Verfahren werden für jedes Bauelement fortlaufend ein netzseitiges Potential, auf dem der netzseitige Anschluss liegt, und ein lastzonenseitiges Potential, auf dem der lastzonenseitige Anschluss liegt, gemessen, und im Falle, dass an einer Hauptleitung ein Erdschluss detektiert wird, wird bei einer Spannungsänderung der an dem Bauelement abfallenden Spannung der Erdschluss der Lastzone zugeordnet, der das Bauelement zugeordnet ist, wenn sich bei der Spannungsänderung das netzseitige Potential stärker als das lastzonenseitige Potential ändert. Dabei wird eine Änderung des netzseitigen Potentials nur dann als stärker als eine Änderung des lastseitigen Potentials eingestuft, wenn die Änderung des netzseitigen Potentials signifikant stärker als die Änderung des lastseitigen Potentials ist. Unter einer signifikant stärkeren Änderung des netzseitigen Potentials gegenüber dem lastzonenseitigen Potential wird ein geeignet quantifizierter Unterschied der Änderungen verstanden, der beispielsweise in Form eines Mindestwertes des absoluten oder relativen Unterschiedes definiert wird, wobei der Mindestwert von der Spannungsänderung abhängen kann. Ferner wird hier und im Folgenden stets angenommen, dass das Gleichstromnetz gegenüber einem Erdpotential isoliert oder über eine hohe Impedanz geerdet ist.

Das erfindungsgemäße Verfahren korreliert also das Detektieren eines Erdschlusses in einem Gleichstromnetz mit Änderungen netz- und lastzonenseitiger Potentiale, die an netz- und lastzonenseitigen Anschlüssen elektrischer Bauelemente anliegen, über die jeweils eine Lastzone direkt oder indirekt mit einer Hauptleitung des Gleichstromnetzes verbunden ist. Dabei wird ausgenutzt, dass bei einem Erdschluss, der in einer Lastzone an einer mit einer Hauptleitung verbundenen Leitung auftritt, sich das lastzonenseitige Potential eines mit dieser Leitung verbundenen Bauelements bei einer Spannungsänderung der an dem Bauelement abfallenden Spannung nicht oder nicht wesentlich ändert und die Spannungsänderung somit im Wesentlichen die Änderung des netzseitigen Potentials bewirkt. Tritt der Erdschluss dagegen nicht in der Lastzone, der das Bauelement zugeordnet ist, sondern an einer anderen Stelle, beispielsweise in einer anderen Lastzone oder an einer Hauptleitung des Gleichstromnetzes, auf, ändert sich das netzseitige Potential nicht oder nicht wesentlich und die Spannungsänderung an dem Bauelement ändert somit im Wesentlichen das lastzonenseitige Potential. Daher signalisiert eine signifikant stärkere Änderung des netzseitigen Potentials gegenüber dem lastzonenseitigen Potential bei einer Spannungsänderung an dem Bauelement, dass der Erdschluss in der Lastzone, der das Bauelement zugeordnet ist, aufgetreten ist. Dies wird erfindungsgemäß zum Orten eines Erdschlusses verwendet, der an einer Hauptleitung des Gleichstromnetzes detektiert wird.

Bei einer Ausgestaltung des Verfahrens wird für wenigstens ein Bauelement die Spannungsänderung aktiv herbeigeführt. Dabei kann vorgesehen sein, dass für jede aktiv an einem Bauelement herbeigeführte Spannungsänderung eine Änderungsdauer, beispielsweise im Bereich von 1 ms bis 1 s, vorgegeben wird und die Spannungsänderung nur für die Änderungsdauer herbeigeführt wird. Diese Ausgestaltung des Verfahrens ermöglicht einen gezielten Test, ob ein Erdschluss in einer Lastzone vorliegt, indem an einem der Lastzone zugeordneten Bauelement aktiv eine Spannungsänderung herbeigeführt wird. Um einen erwünschten Betrieb des Gleichstromnetzes möglichst wenig zu beeinflussen, wird die aktive Spannungsänderung vorzugsweise nur für eine kurze Änderungsdauer herbeigeführt, die für eine zuverlässige Erfassung der netzseitigen und lastzonenseitigen Potentiale ausreicht. Typischerweise reicht dazu eine Änderungsdauer zwischen 1 ms und 1 s aus. Statt eine Spannungsänderung an einem Bauelement aktiv herbeizuführen, kann auch abgewartet werden, bis ein Lastfall eintritt, der von selbst zu der Spannungsänderung führt.

Bei einer weiteren Ausgestaltung des Verfahrens wird für wenigstens ein Bauelement die Spannungsänderung durch eine Stromänderung des Stromflusses durch das Bauelement aktiv herbeigeführt. Insbesondere kann für wenigstens ein Bauelement bei der Stromänderung die Richtung des Stromflusses durch das Bauelement geändert werden. Eine derartige Stromänderung kann beispielsweise durch eine Leistungsänderung einer Last in der Lastzone herbeigeführt werden, der das Bauelement zugeordnet ist.

Bei einer weiteren Ausgestaltung des Verfahrens ist wenigstens ein Bauelement ein durch eine Ansteuerspannung steuerbarer Halbleiterschalter oder wenigstens ein Bauelement weist einen durch eine Ansteuerspannung steuerbaren Halbleiterschalter auf, und die Spannungsänderung an dem Bauelement wird durch eine Änderung der Ansteuerspannung aktiv herbeigeführt. Diese Ausgestaltung des Verfahrens nutzt aus, dass am Eingang einer Lastzone häufig ein Halbleiterschalter vorhanden ist, um die Lastzone dem Gleichstromnetz zuschalten und von dem Gleichstromnetz trennen zu können. Eine aktive Herbeiführung einer Spannungsänderung an einem Halbleiterschalter durch Änderung der Ansteuerspannung ist besonders einfach und insbesondere bei unverändertem Leistungsfluss zwischen der Lastzone und den Hauptleitungen durchführbar.

Bei einer weiteren Ausgestaltung des Verfahrens wird für Lastzonen nacheinander je eine Spannungsänderung an einem der Lastzone zugeordneten Bauelement aktiv herbeigeführt und ausgewertet bis der Erdschluss einer Lastzone zugeordnet wird. Diese Ausgestaltung des Verfahrens ermöglicht eine systematische Suche nach einer Lastzone, in der ein Erdschluss aufgetreten ist.

Eine weitere Ausgestaltung des Verfahrens betrifft Lastzonen, die in mehreren Hierarchieebenen gestaffelt mit dem Gleichstromnetz verbunden sind, wobei jede Lastzone einer obersten Hierarchieebene direkt mit dem Gleichstromnetz verbunden ist und jede Lastzone einer anderen Hierarchieebene mit der über dieser Hierarchieebene liegenden Hierarchieebene verbunden ist. Bei dieser Ausgestaltung des Verfahrens wird für eine Lastzone einer Hierarchieebene eine Spannungsänderung an einem der Lastzone zugeordneten Bauelement erst aktiv herbeigeführt und ausgewertet, nachdem für alle Lastzonen der unter dieser Hierarchieebene liegenden Hierarchieebenen je eine Spannungsänderung an einem der Lastzone zugeordneten Bauelement ausgewertet wurde. Mit anderen Worten sieht diese Ausgestaltung des Verfahrens vor, Spannungsänderungen zunächst in den Lastzonen der untersten Hierarchieebene durchzuführen und anschließend in anderen Lastzonen in aufsteigender Reihenfolge der Hierarchieebenen bis der Erdschluss geortet ist. Dadurch werden durch die Spannungsänderungen in der Regel weniger Lastzonen betroffen als wenn Spannungsänderungen anfänglich in Lastzonen höherer Hierarchieebenen aktiv herbeigeführt werden, da eine Spannungsänderung in einer Lastzone einer Hierarchieebene sich in der Regel auch auf die dieser Lastzone nachgeordneten Lastzonen niedrigerer Hierarchieebenen auswirkt, zumindest wenn die Spannungsänderung auch eine Änderung des Leistungsflusses bewirkt.

Bei einer weiteren Ausgestaltung des Verfahrens werden Spannungsänderungen nur für Bauelemente aktiv herbeigeführt, die direkt oder indirekt mit derjenigen Hauptleitung des Gleichstromnetzes verbunden sind, an der der Erdschluss detektiert wird. Diese Ausgestaltung des Verfahrens vermeidet vorteilhaft unnötige Spannungsänderungen an Bauelementen, die gar nicht mit einer von dem Erdschluss betroffenen Hauptleitung des Gleichstromnetzes verbunden sind.

Bei einer weiteren Ausgestaltung des Verfahrens werden die netzseitigen und lastzonenseitigen Potentiale aller Bauelemente von einer übergeordneten Auswerteeinheit ausgewertet.

Der vorgenannten Ausgestaltung des Verfahrens entspricht ein erstes erfindungsgemäßes Gleichstromnetz, dem mehrere Lastzonen zuschaltbar sind und das folgende Komponenten umfasst:
- für jede Lastzone wenigstens ein elektrisches Bauelement mit einem netzseitigen Anschluss, der direkt oder indirekt mit einer Hauptleitung des Gleichstromnetzes verbunden ist, und einem lastzonenseitigen Anschluss, wobei an dem Bauelement bei einem Stromfluss durch das Bauelement eine Spannung zwischen dem netzseitigen Anschluss und dem lastzonenseitigen Anschluss abfällt,
- für jedes Bauelement eine netzseitige Messeinheit, die dazu eingerichtet ist, fortlaufend ein netzseitiges Potential zu messen, auf dem der netzseitige Anschluss liegt, und eine lastzonenseitige Messeinheit, die dazu eingerichtet ist, ein lastzonenseitiges Potential zu messen, auf dem der lastzonenseitige Anschluss liegt,
- und eine übergeordnete Auswerteeinheit, der die Messsignale aller Messeinheiten zugeführt werden und die dazu eingerichtet ist, im Falle, dass an einer Hauptleitung ein Erdschluss detektiert wird, bei einer Spannungsänderung der Spannung, die an einem der Lastzone zugeordneten Bauelement abfällt, den Erdschluss der Lastzone zuzuordnen, der das Bauelement zugeordnet ist, wenn sich an dem Bauelement bei der Spannungsänderung das netzseitige Potential stärker als das lastzonenseitige Potential ändert.

Bei einer anderen Ausgestaltung des Verfahrens werden das netzseitige Potential und das lastzonenseitige Potential jedes Bauelements für die Lastzone, dem das Bauelement zugeordnet ist, lokal von einer der Lastzone zugeordneten Auswerteeinheit ausgewertet.

Dem entspricht ein zweites erfindungsgemäßes Gleichstromnetz, dem mehrere Lastzonen zuschaltbar sind und das umfasst:
- für jede Lastzone wenigstens ein elektrisches Bauelement mit einem netzseitigen Anschluss, der direkt oder indirekt mit einer Hauptleitung des Gleichstromnetzes verbunden ist, und einem lastzonenseitigen Anschluss, wobei an dem Bauelement bei einem Stromfluss durch das Bauelement eine Spannung zwischen dem netzseitigen Anschluss und dem lastzonenseitigen Anschluss abfällt,
- für jedes Bauelement eine netzseitige Messeinheit, die dazu eingerichtet ist, fortlaufend ein netzseitiges Potential zu messen, auf dem der netzseitige Anschluss liegt, und eine lastzonenseitige Messeinheit, die dazu eingerichtet ist, ein lastzonenseitiges Potential zu messen, auf dem der lastzonenseitige Anschluss liegt,
- und für jede Lastzone eine Auswerteeinheit, die dazu eingerichtet ist, im Falle, dass an einer Hauptleitung ein Erdschluss detektiert wird, bei einer Spannungsänderung der Spannung, die an einem der Lastzone zugeordneten Bauelement abfällt, den Erdschluss dieser Lastzone zuzuordnen, wenn sich an dem Bauelement bei der Spannungsänderung das netzseitige Potential stärker als das lastzonenseitige Potential ändert.

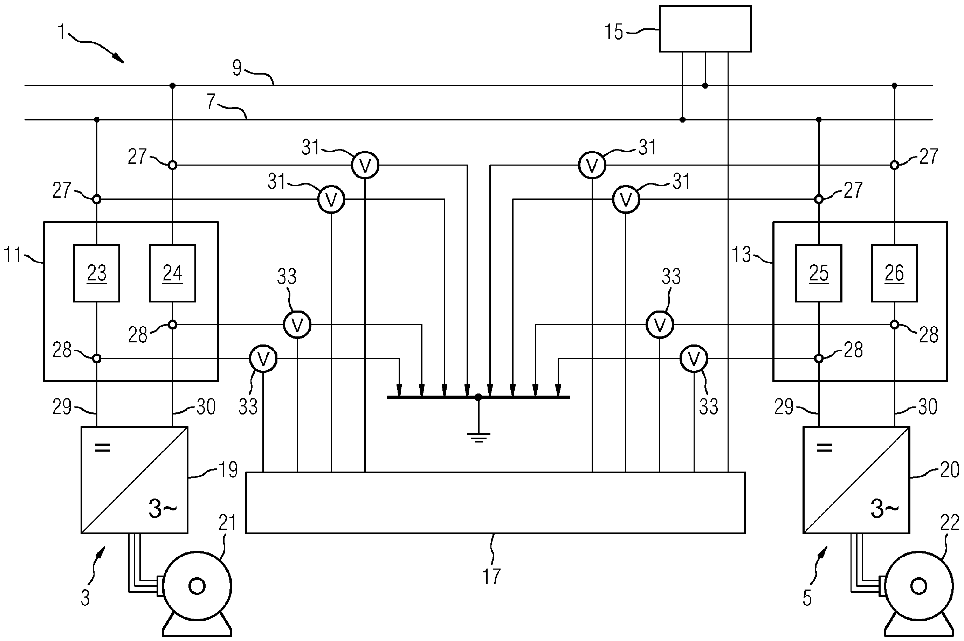

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit der Zeichnung näher erläutert werden.

Dabei zeigt die einzige Figur schematisch ein Gleichstromnetz 1, dem mehrere Lastzonen 3, 5 zuschaltbar sind. Das Gleichstromnetz 1 ist gegenüber einem Erdpotential isoliert oder über eine hohe Impedanz geerdet.

Das Gleichstromnetz 1 weist zwei elektrische Hauptleitungen 7, 9, für jede Lastzone 3, 5 eine Zuschalteinheit 11, 13, eine Erdschlussüberwachungseinheit 15 und eine Auswerteeinheit 17 auf.

In der Figur sind beispielhaft zwei Lastzonen 3, 5 dargestellt, die jeweils einen Stromrichter 19, 20 und eine elektrische Maschine 21, 22 aufweisen.

Eine erste Hauptleitung 7 liegt auf einem ersten Gleichspannungspotential des Gleichstromnetzes 1. Die zweite Hauptleitung 9 liegt auf einem zweiten Gleichspannungspotential des Gleichstromnetzes 1.

Jede Zuschalteinheit 11, 13 ist einer Lastzone 3, 5 zugeordnet, die dem Gleichstromnetz 1 durch die Zuschaltschalteinheit 11, 13 zuschaltbar ist. Jede Zuschalteinheit 11, 13 weist für jede Hauptleitung 7, 9 des Gleichstromnetzes 1 ein elektrisches Bauelement 23 bis 26 auf. Jedes Bauelement 23 bis 26 hat einen netzseitigen Anschluss 27, der mit der jeweiligen Hauptleitung 7, 9 verbunden ist, und einen lastzonenseitigen Anschluss 28, der mit einer Energieversorgungsleitung 29, 30 der Lastzone 3, 5, der das Bauelement 23 bis 26 zugeordnet ist, verbunden ist. An jedem Bauelement 23 bis 26 fällt bei einem Stromfluss durch das Bauelement 23 bis 26 eine Spannung zwischen dem netzseitigen Anschluss 27 und dem lastzonenseitigen Anschluss 28 ab.

Der netzseitige Anschluss 27 jedes Bauelements 23 bis 26 ist mit einer netzseitigen Messeinheit 31 verbunden, die dazu eingerichtet ist, fortlaufend ein netzseitiges Potential zu messen, auf dem der netzseitige Anschluss 27 liegt. Dazu misst die netzseitige Messeinheit 31 eine Spannung zwischen dem netzseitigen Anschluss 27 und dem Erdpotential. Da in dem in der Figur gezeigten Beispiel alle netzseitigen Anschlüsse 27 auf demselben Potential liegen, genügt in diesem Fall auch eine netzseitige Messeinheit 31 zur Bestimmung des netzseitigen Potentials aller netzseitigen Anschlüsse 27 (statt für jeden netzseitigen Anschluss 27 eine separate netzseitige Messeinheit 31 wie in der Figur gezeigt).

Der lastzonenseitige Anschluss 28 jedes Bauelements 23 bis 26 ist mit einer lastzonenseitigen Messeinheit 33 verbunden, die dazu eingerichtet ist, fortlaufend ein lastzonenseitiges Potential zu messen, auf dem der lastzonenseitige Anschluss 28 liegt. Dazu misst die lastzonenseitige Messeinheit 33 eine Spannung zwischen dem lastzonenseitigen Anschluss 28 und dem Erdpotential.

Jede Messeinheit 31, 33 überträgt die von ihr erfassten Messsignale an die Auswerteeinheit 17, entweder über eine Übertragungsleitung oder kabellos, beispielsweise durch Funksignale.

Die Erdschlussüberwachungseinheit 15 ist dazu eingerichtet, einen Erdschluss eines Gleichspannungspotentials des Gleichstromnetzes 1 zu detektieren. Dazu ist die Erdschlussüberwachungseinheit 15 mit jeder Hauptleitung 7, 9 verbunden und dazu eingerichtet, die Spannungen zwischen einem Erdpotential und den Gleichspannungspotentialen, auf denen die Hauptleitungen 7, 9 liegen, zu messen. Ferner ist die Erdschlussüberwachungseinheit 15 dazu eingerichtet, der Auswerteeinheit 17 einen an einer Hauptleitung 7, 9 detektierten Erdschluss zu melden, entweder über eine Übertragungsleitung oder kabellos, beispielsweise durch Funksignale.

Die Auswerteeinheit 17 ist dazu eingerichtet, im Falle eines ihr von der Erdschlussüberwachungseinheit 15 gemeldeten Erdschlusses die Messsignale der Messeinheiten 31, 33 auszuwerten, um den Erdschluss zu orten. Dazu vergleicht die Auswerteeinheit 17 bei einer Spannungsänderung einer an einem Bauelement 23 bis 26 abfallenden Spannung die Werte des netzseitigen Potentials und des lastzonenseitigen Potentials an dem Bauelement 23 bis 26 vor der Spannungsänderung mit den entsprechenden Werten nach der Spannungsänderung. Wenn sich das netzseitige Potential signifikant stärker als das lastzonenseitige Potential ändert, ordnet die Auswerteeinheit 17 den Erdschluss der Lastzone 3, 5 zu, der das Bauelement 23 bis 26 zugeordnet ist. Wenn sich herausstellt, dass an keinem Bauelement 23 bis 26 bei einer Spannungsänderung der an ihm abfallenden Spannung sich das netzseitige Potential signifikant stärker als das lastzonenseitige Potential ändert, wird der Erdschluss der Netzseite, das heißt in diesem Fall der Hauptleitung 7, 9, an der der Erdschluss detektiert wurde, zugeordnet.

Die Bauelemente 23 bis 26 können beispielsweise Halbleiterschalter sein oder aufweisen, die beispielsweise zum Zuschalten der Lastzonen 3, 5 verwendet werden. Alternativ können die Bauelemente 23 bis 26 jedoch auch andere aktive oder passive elektrische Bauelemente (beispielsweise Widerstände) sein. Ferner können auch unterschiedliche Bauelemente 23 bis 26 verwendet werden. Beispielsweise können einige der Bauelemente 23 bis 26 Halbleiterschalter sein oder aufweisen und die anderen Bauelemente 23 bis 26 können andere aktive oder passive elektrische Bauelemente sein.

Die Spannungsänderungen an Bauelementen 23 bis 26, bei denen im Falle eines Erdschlusses die netzseitigen und lastzonenseitigen Potentiale ausgewertet werden, können beispielsweise aktiv herbeigeführt werden. Alternativ kann gewartet werden, bis Lastfälle eintreten, die zu den Spannungsänderungen führen. Es kann auch zunächst abgewartet werden, dass derartige Lastfälle auftreten, und wenn diese nach einer vorgegebenen Zeitspanne nach dem Erdschluss nicht oder nicht für alle Lastzonen 3, 5 eingetreten sind, können für alle Lastzonen 3, 5 oder nur für diejenigen Lastzonen 3, 5, in denen noch keine geeigneten Lastfälle eingetreten sind, Spannungsänderungen aktiv herbeigeführt werden.

Um einen erwünschten Betrieb des Gleichstromnetzes 1 möglichst wenig zu beeinflussen, wird eine Spannungsänderung an einem Bauelement 23 bis 26 aktiv vorzugsweise nur für eine kurze Änderungsdauer herbeigeführt, die für eine zuverlässige Erfassung der netzseitigen und lastzonenseitigen Potentiale ausreicht. Die dazu erforderliche Änderungsdauer hängt von den Komponenten der jeweiligen Zuschalteinheit 11, 13 und dem Erdschlusswiderstand ab, beispielsweise von dem Verhältnis des Erdschlusswiderstands zu betriebsmäßigen Ableitwiderständen und von Leiter-Erde-Kapazitäten der Zuschalteinheit 11, 13 oder der Lastzone 3, 5. Typischerweise beträgt die erforderliche Änderungsdauer zwischen 1 ms und 1 s. Ferner werden Spannungsänderungen an Bauelementen 23 bis 26 aktiv vorzugsweise zu Zeiten durchgeführt, die für die Aufgaben des Gleichstromnetzes 1 unkritisch sind. Eine geeignete Zeitwahl für die Durchführung aktiv herbeigeführter Spannungsänderungen an Bauelementen 23 bis 26 ist in der Regel problemlos möglich, da die Erdschlussortung in der Regel zeitlich unkritisch ist; beispielsweise reicht oftmals eine Erdschlussortung innerhalb eines Tages aus.

Eine Spannungsänderung an einem Bauelement 23 bis 26 kann aktiv beispielsweise durch eine Stromänderung des Stromflusses durch das Bauelement 23 bis 26 herbeigeführt werden, beispielsweise durch eine Leistungsänderung einer Last in der Lastzone 3, 5, der das Bauelement 23 bis 26 zugeordnet ist (im in der Figur dargestellten Beispiel z. B. eine Leistungsänderung einer elektrischen Maschine 21, 22). Insbesondere kann vorgesehen sein, dass bei der Stromänderung die Richtung des Stromflusses durch das Bauelement 23 bis 26 geändert wird.

Wenn ein Bauelement 23 bis 26 ein durch eine Ansteuerspannung steuerbarer Halbleiterschalter ist oder einen derartigen Halbleiterschalter aufweist, kann eine Spannungsänderung ferner aktiv beispielsweise durch eine Änderung der Ansteuerspannung herbeigeführt werden, beispielsweise durch Absenkung einer Gate-Source-Spannung eines als ein MOSFET (Metall-Oxid-Halbleiter-Feldeffekttransistor) ausgebildeten Halbleiterschalters oder einer Basis-Emitter-Spannung eines als ein Biplolartransistor ausgebildeten Halbleiterschalters in die Nähe der Thresholdspannung.

Aktive Spannungsänderungen können ferner nacheinander für verschiedene Lastzonen 3, 5 durchführt werden bis der Erdschluss einer Lastzone 3, 5 zugeordnet wird.

Spannungsänderungen werden ferner vorzugsweise aktiv nur für Bauelemente 23 bis 26 herbeigeführt, die (direkt oder indirekt) mit derjenigen Hauptleitung 7, 9 des Gleichstromnetzes 1 verbunden sind, an der der Erdschluss detektiert wird. In dem in der Figur gezeigten Fall werden beispielsweise im Falle eines an der Hauptleitung 7 detektierten Erdschlusses Spannungsänderungen aktiv vorzugsweise nur an den Bauelementen 23 und 25 herbeigeführt. Entsprechend werden im Falle eines an der Hauptleitung 9 detektierten Erdschlusses Spannungsänderungen aktiv vorzugsweise nur an den Bauelementen 24 und 26 herbeigeführt.

Die anhand der Figur beschriebenen Ausführungsbeispiele eines erfindungsgemäßen Gleichstromnetzes 1 und des erfindungsgemäßen Verfahrens können auf verschiedene Weisen zu weiteren Ausführungsbeispielen abgewandelt werden.

Beispielsweise kann statt einer separaten Auswerteeinheit 17 vorgesehen sein, dass die Erdschlussüberwachungseinheit 15 als die Auswerteeinheit 17 ausgebildet ist beziehungsweise deren Funktionen zusätzlich zum Detektieren von Erdschlüssen übernimmt.

Alternativ kann statt einer übergeordneten Auswerteeinheit 17 für jede Lastzone 3, 5 separat eine Auswerteeinheit 17 vorgesehen sein, die dazu eingerichtet ist, im Falle eines Erdschlusses bei einer Spannungsänderung der Spannung, die an einem der Lastzone 3, 5 zugeordneten Bauelement 23 bis 26 abfällt, den Erdschluss dieser Lastzone 3, 5 zuzuordnen, wenn sich an dem Bauelement 23 bis 26 bei der Spannungsänderung das netzseitige Potential stärker als das lastzonenseitige Potential ändert.

Alle bisher beschriebenen Ausführungsbeispiele können ferner dahin gehend abgewandelt werden, dass für eine Lastzone 3, 5, mehrere oder alle Lastzonen 3, 5 nur je ein Bauelement 23 bis 26 vorgesehen ist, das (direkt oder indirekt) mit einer Hauptleitung 7, 9 verbunden ist und dessen netz- und lastzonenseitigen Potentiale zum Orten eines Erdschlusses gemessen und ausgewertet werden. In diesem Fall kann ein an der anderen Hauptleitung 7, 9 detektierter Erdschluss mit dem erfindungsgemäßen Verfahren allerdings nicht geortet werden, wenn der Erdschluss in einer dieser Lastzonen 3, 5 auftritt. Beispielsweise kann vorgesehen sein, dass nur eine Hauptleitung 7, 9 mit jeder Lastzone 3, 5 über ein Bauelement 23 bis 26 verbunden ist, dessen netz- und lastzonenseitigen Potentiale zum Orten eines Erdschlusses gemessen und ausgewertet werden. In diesem Fall kann mit dem erfindungsgemäßen Verfahren nur ein Erdschluss geortet werden, der an dieser Hauptleitung 7, 9 detektiert wird.

Das erfindungsgemäße Verfahren kann ferner auch für Lastzonen 3, 5 definiert und durchgeführt werden, die in mehreren Hierarchieebenen gestaffelt mit dem Gleichstromnetz 1 verbunden sind, wobei jede Lastzone 3, 5 einer obersten Hierarchieebene direkt über wenigstens ein Bauelement 23 bis 26 mit dem Gleichstromnetz 1 verbunden ist und jede Lastzone 3, 5 einer anderen Hierarchieebene mit der über dieser Hierarchieebene liegenden Hierarchieebene über wenigstens ein Bauelement 23 bis 26 verbunden ist. Als netzseitiger Anschluss eines Bauelements 23 bis 26 einer Lastzone 3, 5 einer von der obersten Hierarchieebene verschiedenen Hierarchieebene wird dann der Anschluss des Bauelements 23 bis 26 zur nächsthöheren Hierarchieebene bezeichnet und die Verbindung dieser Lastzone 3, 5 mit dem Gleichstromnetz 1 wird als indirekt bezeichnet. Wenn für derartig mit einem Gleichstromnetz 1 verbundene Lastzonen 3, 5 eine systematische Ortung eines Erdschlusses mit dem erfindungsgemäßen Verfahren durchgeführt wird, bei der für Lastzonen 3, 5 nacheinander aktiv je eine Spannungsänderung herbeigeführt und ausgewertet wird bis der Erdschluss einer Lastzone 3, 5 zugeordnet wird, dann wird vorzugsweise jede Spannungsänderung für eine Lastzone 3, 5 einer Hierarchieebene erst nach dem Auswerten von Spannungsänderungen für alle Lastzonen 3, 5 der unter dieser Hierarchieebene liegenden Hierarchieebenen aktiv herbeigeführt und ausgewertet. Mit anderen Worten werden also Spannungsänderungen zunächst an Bauelementen 23 bis 26 aktiv herbeigeführt und ausgewertet, die Lastzonen 3, 5 der untersten Hierarchieebene zugeordnet sind, und anschließend in aufsteigender Reihenfolge der Hierarchieebenen an Bauelementen 23 bis 26, die Lastzonen 3, 5 der anderen Hierarchieebenen zugeordnet sind.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den durch die Patentansprüche definierten Schutzumfang der Erfindung zu verlassen.

## Patentansprüche

1. Verfahren zum Orten eines Erdschlusses in einem Gleichstromnetz (1), dem mehrere Lastzonen (3, 5) zuschaltbar sind, wobei jede Lastzone (3, 5) direkt oder indirekt mit wenigstens einer Hauptleitung des Gleichstromnetzes (1) über ein der Lastzone (3, 5) zugeordnetes elektrisches Bauelement (23 bis 26) verbunden ist, das einen netzseitigen Anschluss (27) und einen lastzonenseitigen Anschluss (28) aufweist und an dem bei einem Stromfluss durch das Bauelement (23 bis 26) eine Spannung zwischen dem netzseitigen Anschluss (27) und dem lastzonenseitigen Anschluss (28) abfällt, wobei für jedes Bauelement (23 bis 26)
- fortlaufend ein netzseitiges Potential, auf dem der netzseitige Anschluss (27) liegt, und ein lastzonenseitiges Potential, auf dem der lastzonenseitige Anschluss (28) liegt, gemessen werden **dadurch gekennzeichnet, dass**
- im Falle, dass an einer Hauptleitung (7, 9) ein Erdschluss detektiert wird, bei einer Spannungsänderung der an dem Bauelement (23 bis 26) abfallenden Spannung der Erdschluss der Lastzone (3, 5) zugeordnet wird, der das Bauelement (23 bis 26) zugeordnet ist, wenn sich bei der Spannungsänderung das netzseitige Potential stärker als das lastzonenseitige Potential ändert.

2. Verfahren nach Anspruch 1, wobei für wenigstens ein Bauelement (23 bis 26) die Spannungsänderung aktiv herbeigeführt wird.

3. Verfahren nach Anspruch 2, wobei für jede aktiv an einem Bauelement (23 bis 26) herbeigeführte Spannungsänderung eine Änderungsdauer vorgegeben wird und die Spannungsänderung nur für die Änderungsdauer herbeigeführt wird.

4. Verfahren nach Anspruch 3, wobei jede Änderungsdauer im Bereich von 1 ms bis 1 s vorgegeben wird.

5. Verfahren nach einem der vorhergehenden Ansprüche, wobei für wenigstens ein Bauelement (23 bis 26) die Spannungsänderung durch eine Stromänderung des Stromflusses durch das Bauelement (23 bis 26) aktiv herbeigeführt wird.

6. Verfahren nach Anspruch 5, wobei für wenigstens ein Bauelement (23 bis 26) bei der Stromänderung die Richtung des Stromflusses durch das Bauelement (23 bis 26) geändert wird.

7. Verfahren nach einem der vorhergehenden Ansprüche, wobei wenigstens ein Bauelement (23 bis 26) ein durch eine Ansteuerspannung steuerbarer Halbleiterschalter ist oder einen durch eine Ansteuerspannung steuerbaren Halbleiterschalter aufweist und die Spannungsänderung an dem Bauelement (23 bis 26) durch eine Änderung der Ansteuerspannung aktiv herbeigeführt wird.

8. Verfahren nach einem der vorhergehenden Ansprüche, wobei für Lastzonen (3, 5) nacheinander je eine Spannungsänderung an einem der Lastzone (3, 5) zugeordneten Bauelement (23 bis 26) aktiv herbeigeführt und ausgewertet wird bis der Erdschluss einer Lastzone (3, 5) zugeordnet wird.

9. Verfahren nach einem der vorhergehenden Ansprüche, wobei, wenn die Lastzonen (3, 5) in mehreren Hierarchieebenen gestaffelt mit dem Gleichstromnetz (1) derart verbunden sind, dass jede Lastzone (3, 5) einer obersten Hierarchieebene direkt mit dem Gleichstromnetz (1) verbunden ist und jede Lastzone (3, 5) einer anderen Hierarchieebene mit der über dieser Hierarchieebene liegenden Hierarchieebene verbunden ist, für eine Lastzone (3, 5) einer Hierarchieebene eine Spannungsänderung an einem der Lastzone (3, 5) zugeordneten Bauelement (23 bis 26) erst aktiv herbeigeführt und ausgewertet wird, nachdem für alle Lastzonen (3, 5) der unter dieser Hierarchieebene liegenden Hierarchieebenen je eine Spannungsänderung an einem der Lastzone (3, 5) zugeordneten Bauelement (23 bis 26) ausgewertet wurde.

10. Verfahren nach einem der vorhergehenden Ansprüche, wobei Spannungsänderungen nur für Bauelemente (23 bis 26) aktiv herbeigeführt werden, die direkt oder indirekt mit derjenigen Hauptleitung (7, 9) des Gleichstromnetzes (1) verbunden sind, an der der Erdschluss detektiert wird.

11. Verfahren nach einem der vorhergehenden Ansprüche, wobei die netzseitigen und lastzonenseitigen Potentiale aller Bauelemente (23 bis 26) von einer übergeordneten Auswerteeinheit (17) ausgewertet werden.

12. Verfahren nach einem der Ansprüche 1 bis 10, wobei das netzseitige Potential und das lastzonenseitige Potential jedes Bauelements (23 bis 26) für die Lastzone (3, 5), dem das Bauelement (23 bis 26) zugeordnet ist, lokal von einer der Lastzone (3, 5) zugeordneten Auswerteeinheit (17) ausgewertet werden.

13. Gleichstromnetz (1), dem mehrere Lastzonen (3, 5) zuschaltbar sind, das Gleichstromnetz (1) umfassend
- für jede Lastzone (3, 5) wenigstens ein elektrisches Bauelement (23 bis 26) mit einem netzseitigen Anschluss (27), der direkt oder indirekt mit einer Hauptleitung (7, 9) des Gleichstromnetzes (1) verbunden ist, und einem lastzonenseitigen Anschluss (28), wobei an dem Bauelement (23 bis 26) bei einem Stromfluss durch das Bauelement (23 bis 26) eine Spannung zwischen dem netzseitigen Anschluss (27) und dem lastzonenseitigen Anschluss (28) abfällt,
- für jedes Bauelement (23 bis 26) eine netzseitige Messeinheit (31), die dazu eingerichtet ist, fortlaufend ein netzseitiges Potential zu messen, auf dem der netzseitige Anschluss (27) liegt, und eine lastzonenseitige Messeinheit (33), die dazu eingerichtet ist, ein lastzonenseitiges Potential zu messen, auf dem der lastzonenseitige Anschluss (28) liegt, **dadurch gekennzeichnet, dass** das Gleichstromnetz
- eine übergeordnete Auswerteeinheit (17) umfasst, der die Messsignale aller Messeinheiten (31, 33) zugeführt werden und die dazu eingerichtet ist, im Falle, dass an einer Hauptleitung (7, 9) ein Erdschluss detektiert wird, bei einer Spannungsänderung der Spannung, die an einem der Lastzone (3, 5) zugeordneten Bauelement (23 bis 26) abfällt, den Erdschluss der Lastzone (3, 5) zuzuordnen, der das Bauelement (23 bis 26) zugeordnet ist, wenn sich an dem Bauelement (23 bis 26) bei der Spannungsänderung das netzseitige Potential stärker als das lastzonenseitige Potential ändert.

14. Gleichstromnetz (1), dem mehrere Lastzonen (3, 5) zuschaltbar sind, das Gleichstromnetz (1) umfassend
- für jede Lastzone (3, 5) wenigstens ein elektrisches Bauelement (23 bis 26) mit einem netzseitigen Anschluss (27), der direkt oder indirekt mit einer Hauptleitung (7, 9) des Gleichstromnetzes (1) verbunden ist, und einem lastzonenseitigen Anschluss (28), wobei an dem Bauelement (23 bis 26) bei einem Stromfluss durch das Bauelement (23 bis 26) eine Spannung zwischen dem netzseitigen Anschluss (27) und dem lastzonenseitigen Anschluss (28) abfällt,
- für jedes Bauelement (23 bis 26) eine netzseitige Messeinheit (31), die dazu eingerichtet ist, fortlaufend ein netzseitiges Potential zu messen, auf dem der netzseitige Anschluss (27) liegt, und eine lastzonenseitige Messeinheit (33), die dazu eingerichtet ist, ein lastzonenseitiges Potential zu messen, auf dem der lastzonenseitige Anschluss (28) liegt, **dadurch gekennzeichnet, dass** das Gleichstromnetz
- für jede Lastzone (3, 5) eine Auswerteeinheit (17) umfasst, die dazu eingerichtet ist, im Falle, dass an einer Hauptleitung (7, 9) ein Erdschluss detektiert wird, bei einer Spannungsänderung der Spannung, die an einem der Lastzone (3, 5) zugeordneten Bauelement (23 bis 26) abfällt, den Erdschluss dieser Lastzone (3, 5) zuzuordnen, wenn sich an dem Bauelement (23 bis 26) bei der Spannungsänderung das netzseitige Potential stärker als das lastzonenseitige Potential ändert.

## Claims

1. Method for locating an earth fault in a DC network (1) to which a plurality of load zones (3, 5) can be connected, wherein each load zone (3, 5) is connected directly or indirectly to at least one main line of the DC network (1) via an electrical component (23 to 26) assigned to the load zone (3, 5), which electrical component has a network-side connection (27) and a load-zone-side connection (28) and has a voltage dropped across it between the network-side connection (27) and the load-zone-side connection (28) when current flows through the component (23 to 26), wherein, for each component (23 to 26),
- a network-side potential at which the network-side connection (27) lies and a load-zone-side potential at which the load-zone-side connection (28) lies are continuously measured, **characterized in that**
- in the event that an earth fault is detected on a main line (7, 9), a change in the voltage dropped across the component (23 to 26) results in the earth fault being attributed to the load zone (3, 5) to which the component (23 to 26) is assigned if the voltage change results in the network-side potential changing to a greater extent than the load-zone-side potential.

2. Method according to Claim 1, wherein the voltage change for at least one component (23 to 26) is actively induced.

3. Method according to Claim 2, wherein a change duration is predefined for each voltage change that is actively induced across a component (23 to 26), and the voltage change is induced only for the change duration.

4. Method according to Claim 3, wherein each change duration is predefined in the range from 1 ms to 1s.

5. Method according to one of the preceding claims, wherein the voltage change for at least one component (23 to 26) is actively induced by changing the flow of current through the component (23 to 26).

6. Method according to Claim 5, wherein, for at least one component (23 to 26), the change of current results in the direction of the flow of current through the component (23 to 26) being changed.

7. Method according to one of the preceding claims, wherein at least one component (23 to 26) is a semiconductor switch that can be controlled by way of an actuating voltage, or has a semiconductor switch that can be controlled by way of an actuating voltage, and the voltage change across the component (23 to 26) is actively induced by changing the actuating voltage.

8. Method according to one of the preceding claims, wherein a voltage change across a component (23 to 26) assigned to the load zone (3, 5) is actively induced and evaluated for each of the load zones (3, 5) in succession until the earth fault is attributed to a load zone (3, 5).

9. Method according to one of the preceding claims, wherein, if the load zones (3, 5) are connected to the DC network (1) in staggered fashion in a plurality of hierarchy levels in such a way that each load zone (3, 5) of a highest hierarchy level is connected directly to the DC network (1) and each load zone (3, 5) of another hierarchy level is connected to the hierarchy level situated above this hierarchy level, a voltage change across a component (23 to 26) assigned to a load zone (3, 5) of a hierarchy level is actively induced and evaluated for the load zone (3, 5) only after a voltage change across a component (23 to 26) assigned to the load zone (3, 5) has been evaluated for each of all the load zones (3, 5) of the hierarchy levels situated below this hierarchy level.

10. Method according to one of the preceding claims, wherein voltage changes are actively induced only for components (23 to 26) which are directly or indirectly connected to that main line (7, 9) of the DC network (1) on which the earth fault is detected.

11. Method according to one of the preceding claims, wherein the network-side and load-zone-side potentials of all the components (23 to 26) are evaluated by a superordinate evaluation unit (17).

12. Method according to one of Claims 1 to 10, wherein the network-side potential and the load-zone-side potential of each component (23 to 26) are evaluated locally, for the load zone (3, 5) to which the component (23 to 26) is assigned, by an evaluation unit (17) assigned to the load zone (3, 5).

13. DC network (1) to which a plurality of load zones (3, 5) can be connected, the DC network (1) comprising,
- for each load zone (3, 5), at least one electrical component (23 to 26) having a network-side connection (27), which is connected directly or indirectly to a main line (7, 9) of the DC network (1), and a load-zone-side connection (28), wherein a voltage is dropped across the component (23 to 26) between the network-side connection (27) and the load-zone-side connection (28) when current flows through the component (23 to 26),
- for each component (23 to 26), a network-side measuring unit (31), which is configured to continuously measure a network-side potential at which the network-side connection (27) lies, and a load-zone-side measuring unit (33), which is configured to measure a load-zone-side potential at which the load-zone-side connection (28) lies, **characterized in that** the DC network
- comprises a superordinate evaluation unit (17) to which the measurement signals of all the measuring units (31, 33) are delivered and which is configured so as, in the event that an earth fault is detected on a main line (7, 9), to respond to a change in the voltage dropped across a component (23 to 26) assigned to the load zone (3, 5) by attributing the earth fault to the load zone (3, 5) to which the component (23 to 26) is assigned if the voltage change results in the network-side potential changing at the component (23 to 26) to a greater extent than the load-zone-side potential.

14. DC network (1) to which a plurality of load zones (3, 5) can be connected, the DC network (1) comprising,
- for each load zone (3, 5), at least one electrical component (23 to 26) having a network-side connection (27), which is connected directly or indirectly to a main line (7, 9) of the DC network (1), and a load-zone-side connection (28), wherein a voltage is dropped across the component (23 to 26) between the network-side connection (27) and the load-zone-side connection (28) when current flows through the component (23 to 26),
- for each component (23 to 26), a network-side measuring unit (31), which is configured to continuously measure a network-side potential at which the network-side connection (27) lies, and a load-zone-side measuring unit (33), which is configured to measure a load-zone-side potential at which the load-zone-side connection (28) lies, **characterized in that** the DC network
- comprises, for each load zone (3, 5), an evaluation unit (17) which is configured so as, in the event that an earth fault is detected on a main line (7, 9), to respond to a change in the voltage dropped across a component (23 to 26) assigned to the load zone (3, 5) by attributing the earth fault to this load zone (3, 5) if the voltage change results in the network-side potential changing at the component (23 to 26) to a greater extent than the load-zone-side potential.

## Revendications

1. Procédé de localisation d'une fuite à la terre dans un réseau à courant continu (1) auquel plusieurs zones de charge (3, 5) peuvent être raccordées, dans lequel chaque zone de charge (3, 5) est reliée directement ou indirectement à au moins une ligne principale du réseau à courant continu (1) par un composant électrique (23 à 26) affecté à la zone de charge (3, 5), qui présente un raccord côté réseau (27) et un raccord côté zone de charge (28) et auquel une tension entre le raccord côté réseau (27) et le raccord côté zone de charge (28) diminue lors d'une conduction de courant à travers le composant (23 à 26), dans lequel pour chaque composant (23 à 26)
- un potentiel côté réseau sur lequel se situe le raccord côté réseau (27), et un potentiel côté zone de charge sur lequel se situe le raccord côté zone de charge (28), sont mesurés en continu, **caractérisé en ce que**
- dans le cas où une fuite à la terre est détectée à une ligne principale (7, 9), lors d'une modification de tension de la tension diminuant au composant (23 à 26), la fuite à la terre est affectée à la zone de charge (3, 5) à laquelle est affecté le composant (23 à 26), lorsque lors de la modification de tension, le potentiel côté réseau se modifie plus fortement que le potentiel côté zone de charge.

2. Procédé selon la revendication 1, dans lequel pour au moins un composant (23 à 26) la modification de tension est provoquée activement.

3. Procédé selon la revendication 2, dans lequel pour chaque modification de tension provoquée activement à un composant (23 à 26), une durée de modification est prédéfinie et la modification de tension est provoquée uniquement pour la durée de modification.

4. Procédé selon la revendication 3, dans lequel chaque durée de modification est prédéfinie dans la plage de 1 ms à 1 s.

5. Procédé selon l'une des revendications précédentes, dans lequel pour au moins un composant (23 à 26), la modification de tension est provoquée activement par une modification de courant de la conduction de courant à travers le composant (23 à 26).

6. Procédé selon la revendication 5, dans lequel pour au moins un composant (23 à 26), lors de la modification de courant, le sens de la conduction de courant à travers le composant (23 à 26) est modifié.

7. Procédé selon l'une des revendications précédentes, dans lequel au moins un composant (23 à 26) est un commutateur à semi-conducteur pouvant être commandé par une tension de commande ou présente un commutateur à semi-conducteur pouvant être commandé par une tension de commande et la modification de tension au composant (23 à 26) peut être provoquée activement par une modification de la tension de commande.

8. Procédé selon l'une des revendications précédentes, dans lequel pour des zones de charge (3, 5) l'une après l'autre une modification de tension à un composant (23 à 26) affecté à la zone de charge (3, 5) est provoquée activement et évaluée jusqu'à ce que la fuite à la terre soit attribuée à une zone de charge (3, 5).

9. Procédé selon l'une des revendications précédentes, dans lequel, lorsque les zones de charge (3, 5) sont reliées au réseau à courant continu (1) en étant échelonnées en plusieurs niveaux hiérarchiques de sorte que chaque zone de charge (3, 5) d'un niveau hiérarchique maximal est reliée directement au réseau à courant continu (1) et chaque zone de charge (3, 5) d'un autre niveau hiérarchique est reliée au niveau hiérarchique se situant au-dessus de ce niveau hiérarchique, pour une zone de charge (3, 5) d'un niveau hiérarchique, une modification de tension à un composant (23 à 26) affecté à la zone de charge (3, 5) est provoquée activement et évaluée uniquement après que pour toutes les zones de charge (3, 5) des niveaux hiérarchiques se situant sous ce niveau hiérarchique, à chaque fois une modification de tension a été évaluée à un composant (23 à 26) affecté à la zone de charge (3, 5).

10. Procédé selon l'une des revendications précédentes, dans lequel des modifications de tension sont provoquées activement uniquement pour des composants (23 à 26) qui sont reliés directement ou indirectement à la ligne principale (7, 9) du réseau à courant continu (1), à laquelle la fuite à la terre est détectée.

11. Procédé selon l'une des revendications précédentes, dans lequel les potentiels côté réseau et côté zone de charge de tous les composants (23 à 26) sont évalués par une unité d'évaluation prioritaire (17).

12. Procédé selon l'une des revendications 1 à 10, dans lequel le potentiel côté réseau et le potentiel côté zone de charge de chaque composant (23 à 26) pour la zone de charge (3, 5) auquel est affecté le composant (23 à 26), sont évalués localement par une unité d'évaluation (17) affectée à la zone de charge (3, 5).

13. Réseau à courant continu (1) auquel peuvent être raccordées plusieurs zones de charge (3, 5), le réseau à courant continu (1) comprenant
- pour chaque zone de charge (3, 5) au moins un composant électrique (23 à 26) avec un raccord côté réseau (27), qui est relié directement ou indirectement à une ligne principale (7, 9) du réseau à courant continu (1), et un raccord côté zone de charge (28), dans lequel une tension entre le raccord côté réseau (27) et le raccord côté zone de charge (28) diminue au composant (23 à 26) lors d'une conduction de courant à travers le composant (23 à 26),
- pour chaque composant (23 à 26) une unité de mesure côté réseau (31), qui est disposée pour mesurer en continu un potentiel côté réseau sur lequel se situe le raccord côté réseau (27), et une unité de mesure côté zone de charge (33), qui est disposée pour mesurer un potentiel côté zone de charge, sur lequel se situe le raccord côté zone de charge (28), **caractérisé en ce que** le réseau à courant continu
- comprend une unité d'évaluation prioritaire (17) à laquelle sont fournis les signaux de mesure de toutes les unités de mesure (31, 33) et qui est disposée, dans le cas où une fuite à la terre est détectée à une ligne principale (7, 9), lors d'une modification de tension de la tension qui diminue à un composant (23 à 26) affecté à la zone de charge (3, 5), pour affecter la fuite à la terre à la zone de charge (3, 5), à laquelle est affecté le composant (23 à 26), lorsque au composant (23 à 26), lors de la modification de tension, le potentiel côté réseau se modifie plus fortement que le potentiel côté zone de charge.

14. Réseau à courant continu (1) auquel plusieurs zones de charge (3, 5) peuvent être raccordées, le réseau à courant continu (1) comprenant
- pour chaque zone de charge (3, 5) au moins un composant électrique (23 à 26) avec un raccord côté réseau (27) qui est relié directement ou indirectement à une ligne principale (7, 9) du réseau à courant continu (1), et un raccord côté zone de charge (28), dans lequel une tension entre le raccord côté réseau (27) et le raccord côté zone de charge (28) diminue au composant (23 à 26) lors d'une conduction de courant à travers le composant (23 à 26),
- pour chaque composant (23 à 26) une unité de mesure côté réseau (31) qui est disposée pour mesurer en continu un potentiel côté réseau, sur lequel se situe le raccord côté réseau (27), et une unité de mesure côté zone de charge (33) qui est disposée pour mesurer un potentiel côté zone de charge, sur lequel se situe le raccord côté zone de charge (28), **caractérisé en ce que** le réseau à courant continu
- pour chaque zone de charge (3, 5) comprend une unité d'évaluation (17) qui est disposée, dans le cas où une fuite à la terre est détectée sur une ligne principale (7, 9), lors d'une modification de tension de la tension qui diminue à un composant (23 à 26) affecté à la zone de charge (3, 5), pour affecter la fuite à la terre à cette zone de charge (3, 5), lorsque au composant (23 à 26), lors de la modification de tension, le potentiel côté réseau se modifie plus fortement que le potentiel côté zone de charge.
